Europäisches Patentamt

European Patent Office

Office européen des brevets

(11) Numéro de publication : **0 159 201**
**B1**

(12) # FASCICULE DE BREVET EUROPÉEN

(45) Date de publication du fascicule du brevet :
27.07.88

(51) Int. Cl.⁴ : **G 01 R 19/22**

(21) Numéro de dépôt : **85400105.4**

(22) Date de dépôt : **23.01.85**

(54) Procédé et dispositif de mesure du courant dans un réseau triphasé.

(30) Priorité : **26.03.84 FR 8404635**

(43) Date de publication de la demande :
**23.10.85 Bulletin 85/43**

(45) Mention de la délivrance du brevet :
**27.07.88 Bulletin 88/30**

(84) Etats contractants désignés :
**AT BE CH DE GB IT LI LU NL SE**

(56) Documents cités :
FR-A- 2 106 732
FR-A- 2 344 160
IEEE TRANSACTIONS ON INDUSTRY APPLICA-
TIONS, vol. IA-19, no. 1, janvier/février 1983, pages
113-119, IEEE, New York, US; S.B. DEWAN et al.: "A
microprocessor-based controller for a three-phase
controlled rectifier bridge"

(73) Titulaire : **LA TELEMECANIQUE ELECTRIQUE**
**33 bis, avenue du Maréchal Joffre**
**F-92000 Nanterre (FR)**

(72) Inventeur : **Parisel, Jacques**
**Résidence la Grille Royale Mesnil le Roi**
**F-78600 Maisons Laffitte (FR)**
Inventeur : **Fauvet, Jean Pierre**
**63, rue Cramail**
**F-92500 Rueil Malmaison (FR)**

(74) Mandataire : **Marquer, Francis et al**
**CABINET MOUTARD 35, avenue Victor Hugo Rési-**
**dence Champfleury**
**F-78180 Voisins-le-Bretonneux (FR)**

Jouve, 18, rue St-Denis, 75001 Paris, France

## Description

La présente invention concerne un procédé de mesure d'un courant prélevé par une charge sur un réseau triphasé, plus particulièrement, mais non exclusivement, au moyen d'un pont redresseur commandé.

Pour mesurer le courant prélevé sur un réseau triphasé au moyen d'un pont redresseur commandé, il est connu d'utiliser soit en aval du pont un shunt de lecture du courant, soit en amont du pont deux ou trois transformateurs d'intensité dont le primaire est associé à chaque fois à une phase du réseau.

De telles mesures de courant sont notamment exploitées dans des boucles de régulation de courant de moteurs à courant continu ou alternatif, dans des systèmes de protection contre les surintensités ou dans des systèmes de signalisation.

Il s'avère que les procédés de mesure connus sont dépourvus d'isolement lorsqu'ils mettent en œuvre des shunts de lecture du courant ou bien sont de mise en œuvre coûteuse lorsqu'ils font intervenir plusieurs transformateurs d'intensité. Il en est de même dans le cas d'un procédé utilisant un transformateur dont l'enroulement primaire est traversé par chacune des alternances du courant triphasé et dont les enroulements secondaires alimentent des ponts redresseurs monophasés, comme décrit dans le brevet FR-A-2 106 732.

L'invention a notamment pour but d'éviter ces inconvénients et vise à simplifier la mesure du courant transmis à une charge par un réseau triphasé en utilisant pour cette mesure un seul transformateur d'intensité.

Pour parvenir à ce résultat, elle propose un procédé de mesure de courant prélevé par une charge sur un réseau alternatif triphasé, qui comprend les étapes suivantes :

— la mesure du côté du réseau alternatif de la différence entre les courants circulant dans deux des phases d'alimentation,

— la détermination de la valeur absolue de cette différence, et

— l'affectation à la valeur absolue du signal résultant d'un coefficient de correction k pour obtenir un signal de sortie représentatif du courant circulant dans la charge.

De préférence, dans le cas où la charge est alimentée à partir du réseau triphasé, par l'intermédiaire d'un pont redresseur triphasé comprenant six éléments interrupteurs pilotés par un circuit logique de commande de manière à obtenir, pour chacun des conducteurs de phase du réseau, un courant périodique de forme crénelée dont la période T est divisée en six parties de durée T/6, on attribue au coefficient de correction une valeur $k_1$ dans les parties T/6 de chaque période T du courant du réseau où la valeur absolue de la susdite différence est double de la valeur à mesurer, et une valeur $k_2 = 2 k_1$ dans les parties restantes de chaque période.

On comprend que le traitement décrit du signal de différence entre deux courants de phase côté réseau fournit de manière extrêmement simple une mesure suffisamment précise du courant. Dans le cas où la charge est alimentée par le réseau triphasé au moyen d'un pont redresseur commandé, la commutation du coefficient de correction de la valeur $k_1$ à la valeur $k_2$ et vice versa est assurée de manière synchrone à la commande des éléments interrupteurs du pont de puissance.

L'invention concerne également un dispositif de mise en œuvre du procédé précédemment décrit, ce dispositif comprenant un circuit de mesure du courant muni d'un transformateur unique d'intensité, d'un redresseur et d'un circuit de traitement ; le transformateur d'intensité est associé à deux conducteurs de phase du réseau alternatif, les deux conducteurs étant montés dans le transformateur d'intensité de façon que le courant du secondaire de celui-ci soit représentatif de la différence des courants dans les deux conducteurs ; le redresseur permet le redressement pleine onde du courant du secondaire du transformateur d'intensité, les bornes de courant continu du redresseur étant reliées à un circuit de traitement autorisant la correction du signal redressé.

Le circuit de traitement peut être un circuit analogique présentant deux entrées dont l'une est soumise à une amplification de gain affecté d'un coefficient de correction par rapport à l'autre, et une sortie reliée à un dispositif d'exploitation, un commutateur étant disposé entre le redresseur et le circuit de traitement pour valider l'une ou l'autre des deux entrées de celui-ci. Dans le cas où l'alimentation de la charge s'effectue à partir du réseau triphasé par l'intermédiaire d'un pont redresseur de puissance, la validation des entrées s'effectue de préférence en synchronisme avec les ordres donnés par un dispositif logique de commande des composants du pont redresseur triphasé.

Le circuit de traitement peut également être un organe de calcul logique, par exemple un microprocesseur, délivrant des valeurs $k_1$ et $k_2$ du coefficient de correction.

Dans un mode de réalisation préférentiel, le commutateur et, le cas échéant, les composants du pont redresseur de puissance sont commandés par une logique gérée par un même microprocesseur ou par un même circuit électronique remplissant les fonctions de commande dudit microprocesseur.

Les diverses particularités ainsi que les avantages de l'invention apparaîtront clairement à la lumière de la description ci-après d'un exemple de réalisation non limitatif, avec référence aux dessins annexés dans lesquels :

La figure 1 représente un schéma d'un dispositif de mesure associé à un pont triphasé à thyristors pour la mise en œuvre du procédé

conforme à l'invention ;

Les figures 2a à 2f montrent les chronogrammes simplifiés des différents courants circulant dans le dispositif de la figure 1 ;

La figure 3 est un tableau logique montrant la correspondance entre la conduction des thyristors et l'état du commutateur.

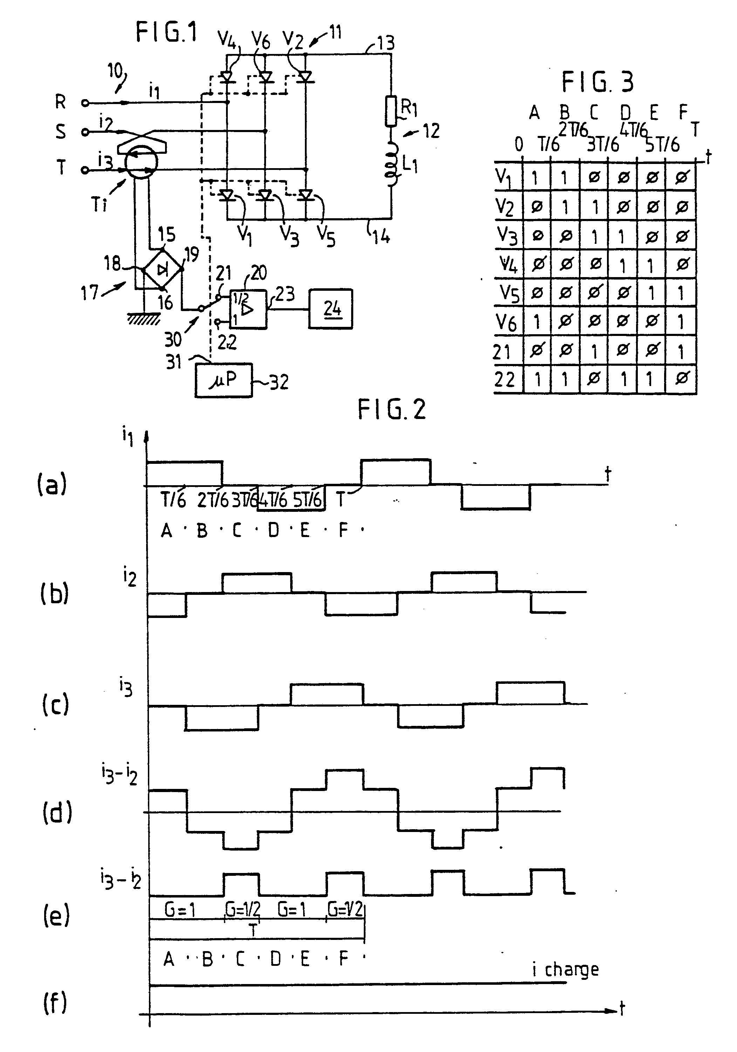

Le dispositif illustré par la figure 1 comprend un réseau alternatif triphasé 10 dont les trois conducteurs de phase R, S, T parcourus par des courants respectifs $i_1$, $i_2$, $i_3$ sont reliés à un pont redresseur triphasé 11. Dans le cas représenté, le pont redresseur triphasé 11 est un pont à thyristors $V_1$ à $V_6$ ; les phases R, S, T sont respectivement reliées aux points intermédiaires entre les thyristors $V_1$, $V_4$ ; $V_3$, $V_6$ ; $V_5$, $V_2$. Il est évident que le pont peut également être constitué au moyen d'autres dispositifs commandés électroniques ou électromécaniques, par exemple par des thyristors GTO, des transistors ou des interrupteurs.

Le pont triphasé 11 est destiné à alimenter une charge inductive 12, par exemple constituée par un moteur et représentée par une résistance $R_1$ et une inductance $L_1$, par l'intermédiaire de deux conducteurs 13 et 14.

Un transformateur unique d'intensité Ti est associé à deux conducteurs de phase, par exemple S et T ; on notera que le conducteur S est bouclé pour que le signal disponible au secondaire du transformateur soit représentatif de la différence $i_3$ - $i_2$.

Le secondaire du transformateur Ti est relié aux bornes de courant alternatif 15, 16 d'un redresseur pleine onde unique 17 dont les bornes de courant continu 18, 19 sont reliées respectivement à un circuit de traitement 20 via un commutateur 30.

Le circuit de traitement 20 est un amplificateur opérationnel à deux entrées 21, 22 affectées respectivement d'un gain $k_1 = 1/2$ et $k_2 = 1$ afin de délivrer à une sortie 23 un signal image du courant circulant dans la charge et disponible pour un dispositif d'exploitation 24, par exemple pour une boucle de régulation de courant.

Le commutateur 30 est relié à un port 31 d'un microprocesseur 32 qui délivre aux thyristors $V_1$ - $V_6$ les ordres de commutation et qui assure donc de manière synchrone l'aiguillage du signal de sortie du redresseur 17 vers l'entrée 21 ou vers l'entrée 22 du circuit de traitement 20.

La mise en œuvre du procédé et le fonctionnement du dispositif décrits sont vus à présent.

Les courants $i_1$, $i_2$, $i_3$ circulant dans les conducteurs de phase respectifs R, S, T ont en fonction du temps une forme schématisée par les créneaux représentés sur les figures 2a, 2b, 2c.

Le transformateur d'intensité Ti produit à son secondaire l'onde crénelée illustrée par la figure 2d et le redresseur 17 délivre à sa borne 19 l'onde représentée figure 2e. Le commutateur 30 relie alternativement la borne 19 à la borne 21 correspondant au gain 1/2 et à la borne 22 correspondant au gain 1. La liaison 19-21 a lieu dans les intervalles C et F de chaque période T (figures 2a et 2e) du courant réseau, pour corriger le signal $i_3$ - $i_2$ dont la valeur est dans ces intervalles double de la valeur à mesurer. La liaison 19-22 a lieu dans les intervalles A, B, D, E de chaque période T.

Le microprocesseur 32 délivre par le port 31 l'ordre approprié au commutateur 30 en même temps qu'il délivre les ordres d'ouverture et éventuellement de fermeture des thyristors, la correspondance entre la conduction des thyristors et l'état du commutateur 30 étant indiquée par le tableau logique de la figure 3 pour les différents intervalles A à F.

Le circuit de traitement analogique 20 et/ou le commutateur 30 tels que décrits peuvent bien entendu être remplacés par un organe logique de traitement interne au microprocesseur et assurant les mêmes fonctions que ledit circuit et/ou ledit commutateur. D'autre part, on peut utiliser au lieu d'un microprocesseur tout circuit électronique assurant les fonctions appropriées de commutation du coefficient de correction et de traitement du signal.

Bien entendu, il est possible d'apporter d'autres modifications au mode de réalisation décrit sans sortir du cadre de l'invention. Les valeurs indiquées pour $k_1$ et $k_2$ peuvent bien entendu varier tout en restant dans la relation $k_2 = 2 K_1$. Le procédé et le dispositif décrits sont applicables non seulement à des régulations de moteurs, mais également à des systèmes de protection contre les surintensités et à des systèmes de signalisation.

**Revendications**

1. Procédé de mesure du courant prélevé par une charge sur un réseau alternatif triphasé, caractérisé en ce qu'il comprend :

— la mesure du côté du réseau alternatif de la différence entre les courants circulant dans deux des phases d'alimentation,

— la détermination de la valeur absolue de cette différence, et

— l'affectation à la valeur absolue du signal obtenu d'un coefficient de correction k pour obtenir un signal de sortie représentatif du courant circulant dans la charge.

2. Procédé selon la revendication 1, caractérisé en ce, dans le cas où la charge est alimentée à partir du réseau triphasé, par l'intermédiaire d'un pont redresseur triphasé comprenant six éléments interrupteurs pilotés par un circuit logique de commande de manière à obtenir, pour chacun des conducteurs de phase du réseau, un courant périodique de forme crénelée dont la période T est divisée en six parties de durée T/6, on attribue au coefficient de correction une valeur $k_1$ dans les parties T/6 de chaque période T du courant du réseau où la valeur absolue de la susdite différence est double de la valeur à mesurer du courant, et une valeur $k_2 = 2 k_1$ dans les parties restantes de chaque période.

3. Procédé selon la revendication 2, caractérisé en ce que la commutation du coefficient de correction de la valeur $k_1$ à la valeur $k_2$ et vice versa est assurée de manière synchrone à la commande des éléments interrupteurs du pont.

4. Dispositif pour la mesure du courant prélevé par une charge (12) sur un réseau alternatif triphasé conformément au procédé selon la revendication 1, caractérisé en ce qu'il comprend un transformateur unique d'intensité Ti, un redresseur (17) et un circuit de traitement (20), le transformateur d'intensité Ti étant associé à deux conducteurs de phase S, T du réseau alternatif, les deux conducteurs étant montés dans le transformateur d'intensité Ti de façon que le courant du secondaire de celui-ci soit représentatif de la différence du courant dans les deux conducteurs S, T, le redresseur (17) servant au redressement pleine onde du courant du secondaire du transformateur d'intensité Ti, les bornes de courant continu du redresseur (17) étant reliées au circuit de traitement (20) affecté à la correction du signal redressé.

5. Dispositif selon la revendication 4, dans lequel la charge (12) est alimentée à partir du réseau triphasé par l'intermédiaire d'un pont redresseur triphasé (11) comprenant six éléments interrupteurs (V1-V6) pilotés par un circuit logique de commande, de manière à obtenir pour chacun des conducteurs de phase du réseau, un courant périodique de forme crénelée dont la période T est divisée en six parties de durée T/6, caractérisé en ce qu'il comprend un commutateur (30) disposé entre le redresseur (17) et le circuit de traitement (20) pour attribuer au coefficient de correction une valeur $k_1$ dans les parties T/6 de chaque période T du courant du réseau où la valeur absolue du signal délivré par le susdit transformateur Ti présente une valeur double de la valeur à mesurer du courant, et une valeur $k_2 = 2 k_1$ dans les parties restantes de chaque période.

6. Dispositif selon l'une des revendications 4 et 5, caractérisé en ce que le circuit de traitement (20) présente deux entrées (21, 22) dont l'une est soumise à une amplification de gain affecté d'un coefficient de correction $k_2$ double par rapport au coefficient k1 affectant l'amplification correspondant à l'autre entrée, et une sortie (23) reliée à un dispositif d'exploitation (24).

7. Dispositif selon la revendication 5, caractérisé en ce que la validation des entrées (21, 22) du circuit de traitement (20) s'effectue en synchronisme avec les ordres donnés par le circuit logique de commande des éléments interrupteurs (V1-V6) du pont redresseur triphasé (11).

8. Dispositif selon la revendication 5, caractérisé en ce que le commutateur (30) et les éléments interrupteurs ($V_1$-$V_6$) du pont redresseur triphasé (11) sont commandés de manière synchrone par une logique gérée par un microprocesseur (32).

9. Dispositif selon la revendication 5, caractérisé en ce que le commutateur (30) et les éléments interrupteurs ($V_1$-$V_6$) du pont redresseur triphasé (11) sont commandés par un même circuit électronique de commande et de synchronisation.

10. Dispositif selon la revendication 4, caractérisé en ce que le circuit de traitement (20) est un organe de calcul logique apte à déterminer par calcul numérique les deux valeurs $k_1$, $k_2$ du coefficient de correction.

11. Dispositif selon la revendication 10, caractérisé en ce que l'organe de calcul logique est constitué par un microprocesseur (32).

**Claims**

1. Method of measuring the current drawn by a load from a three-phase AC network, characterized in that it comprises :
— measurement from the AC network side of the difference between the currents flowing in two of the supply phases,
— determination of the absolute value of this difference, and
— assignment to the absolute value of the resulting signal of a correction coefficient k so as to obtain an output signal representative of the current flowing through the load.

2. Method according to claim 1, characterized in that, in the case where the load is fed from the three-phase network through a three-phase rectifier bridge having six switching elements driven by a control logic circuit so as to obtain, for each of the phase conductors of the network, a periodic current of square wave form whose period T is divided into six parts of duration T/6, a value $k_1$ is attributed to the correction coefficient in the parts T/6 of each period T of the current of the network where the absolute value of said difference is twice the value to be measured of the current, and a value $k_2 = 2k_1$ in the remaining parts of each period.

3. Method according to claim 2, characterized in that switching of the correction coefficient from the value $k_1$ to the value $k_2$ and vice versa is provided synchronously with the control of the switching elements of the power bridge.

4. Device for measuring the current drawn by a load (12) from a three-phase AC network in accordance with the method according to claim 1, characterized in that it comprises a single current transformer Ti, a rectifier (17) and a processing circuit (20) ; the current transformer Ti being associated with two phase conductors S, T, of the AC network, the two conductors being mounted in the current transformer Ti so that the current of the secondary thereof is representative of the difference between the currents in both conductors S, T ; the rectifier (17) provides full wave rectification of the secondary current of the current transformer Ti, the DC current terminals of the rectifier (17) being connected to the processing circuit (20) allowing correction of the rectified signal.

5. Device according to claim 4, in which the load (12) is fed from the three-phase network through a three-phase rectifier bridge (11) comprising six switching elements ($V_1$ - $V_6$) driven by a logic control circuit, so as to obtain for each of the phase conductors of the network a periodic current of square wave form whose period T is divided into six parts of duration T/6, characterized in that it comprises a switch (30) disposed between the rectifier (17) and the processing circuit (20) for attributing to the correction coefficient a value $k_1$ in the parts T/6 of each period T of the current of the network where the absolute value of the signal delivered by said transformer Ti has a value double the value to be measured of the current and a value $k_2 = 2k_1$ in the remaining parts of each period.

6. Device according to one of claims 4 and 5, characterized in that the processing circuit (20) has two inputs (21, 22) one of which is subjected to a gain amplification to which a correction coefficient $k_2$ is attributed which is double the coefficient $k_1$ affecting the amplification corresponding to the other input and an output (23) connected to a user device (24).

7. Device according to claim 5, characterized in that the inputs (21, 22) of the processing circuit (20) are enabled in synchronism with the orders given by the logic device controlling the switching elements ($V_1$ - $V_6$) of the three-phase rectifier bridge (11).

8. Device according to claim 5, characterized in that the switch (30) and the switching elements ($V_1$ - $V_6$) of the three-phase rectifier bridge (11) are controlled synchronously by means of a logic controlled by a microprocessor (32).

9. Device according to claim 5, characterized in that switch (30) and the switching elements ($V_1$ -$V_6$) of the three-phase rectifier bridge (11) are controlled by the same electronic control and synchronizing circuit.

10. Device according to claim 4, characterized in that the processing circuit (20) is a logic computing member adapted for determining by digital computation the two values $k_1$, $k_2$ of the correction coefficient.

11. Device according to claim 10, characterized in that the logic computing member is formed by a microprocessor (32).

## Patentansprüche

1. Verfahren zur Messung des von einer Last einem Dreiphasenwechselstromnetz entnommenen Stromes, dadurch gekennzeichnet, dass es beinhaltet :
— die Messung, vom Wechselstromnetz aus, der Differenz zwischen den in zweien der Versorgungsphasen fliessenden Strömen,
— die Bestimmung des absoluten Wertes dieser Differenz, und
— die Zuordnung zum absoluten Wert des so erhaltenen Signals von einem Korrekturkoeffizienten k, um ein Ausgangssignal zu erhalten, welches repräsentativ ist für den in der Last fliessenden Strom.

2. Verfahren nach Anspruch 1, dadurch gekennzeichnet, dass, wenn die Last von einem Dreiphasennetz versorgt wird, mittels einer Dreiphasengleichrichterbrücke mit sechs Schaltelementen, die von einer logischen Steuerschaltung gesteuert werden, um für jeden der Netzphasenleiter einen periodischen rechteckförmigen Strom zu erhalten, dessen Periode T in sechs Abschnitte mit einer Dauer T/6 unterteilt ist, dem Korrekturkoeffizienten ein Wert $k_1$ in den Abschnitten T/6 einer jeden Periode T des Netzstromes zugeteilt ist, wo der absolute Wert der besagten Differenz gleich dem Doppelten des zu messenden Stromwertes ist, und ein Wert $k_2 = 2 k_1$ in den restlichen Abschnitten einer jeden Periode.

3. Verfahren nach Anspruch 2, dadurch gekennzeichnet, dass die Umwandlung des Korrekturkoeffizienten vom Wert $k_1$ in den Wert $k_2$ und umgekehrt synchron mit der Steuerung der Schaltelemente der Brücke erfolgt.

4. Vorrichtung zur Messung des von einer Last (12) einem Dreiphasenwechselstromnetz entnommenen Stromes, nach dem Verfahren gemäss Anspruch 1, dadurch gekennzeichnet, dass sie einen einzigen Stromwandler Ti enthält, einen Gleichrichter (17) und einen Verarbeitungskreis (20), wobei der Stromwandler Ti zwei Phasenleitern S, T des Wechselstromnetzes zugeordnet ist und die beiden Leiter in den Stromwandler Ti so eingebaut sind, dass der Strom von dessen Sekundar repräsentativ ist für den Stromunterschied in den beiden Leitern S, T, wobei der Gleichrichter (17) zum Vollwellengleichrichten des Sekundarstromes des Stromwandlers Ti dient und die Gleichstromklemmen des Gleichrichters (17) an den Verarbeitungskreis (20) angeschlossen sind, welcher das gleichgerichtete Signal korrigiert.

5. Vorrichtung nach Anspruch 4, in dem die Last (12) von einem Dreiphasennetz versorgt wird, mittels einer Dreiphasengleichrichterbrücke (11) mit sechs Schaltelementen ($V_1$ - $V_6$), die von einem logischen Steuerkreis gesteuert werden, um für jeden der Phasenleiter des Netzes einen periodischen rechteckförmigen Strom zu erhalten, dessen Periode T in sechs Abschnitte mit der Dauer T/6 unterteilt ist, dadurch gekennzeichnet, dass sie einen zwischen den Gleichrichter (17) und den Verarbeitungskreis (20) eingebauten Umschalter (30) enthält, um dem Korrekturkoeffizienten einen Wert $k_1$ mitzuteilen, in den Abschnitten T/6 einer jeden Periode T des Netzstromes, wo der absolute Wert des vom besagten Transformator Ti abgegebenen Signals den doppelten Wert wie der zu messenden Stromwert hat und einen Wert $k_2 = 2k_1$ in den restlichen Abschnitten einer jeden Periode.

6. Vorrichtung nach einem der Ansprüche 4 und 5, dadurch gekennzeichnet, dass der Verarbeitungskreis (20) zwei Eingaben (21, 22) besitzt, deren eine von einem Gewinnverstärker beaufschlagt wird, dem ein Korrekturkoeffizient $k_2$ zugeteilt ist, welcher den doppelten Wert hat, wie der Koeffizient $k_1$, welcher die der anderen Eingabe entsprechende Verstärkung beaufschlagt, und eine Ausgabe (23), die einer Benutzervorrichtung (24) angeschlossen ist.

7. Vorrichtung nach Anspruch 5, dadurch gekennzeichnet, dass die Gültigmachung der Eingaben (21, 22) des Verarbeitungskreises (20) gleichzeitig mit den Befehlen erfolgt, die vom logischen Steuerkreis ausgegeben werden, welcher die Schaltelemente ($V_1$ - $V_6$) der Dreiphasengleichrichterbrücke (11) steuert.

8. Vorrichtung nach Anspruch 5, dadurch gekennzeichnet, dass der Umschalter (30) und die Schaltelemente ($V_1$-$V_6$) der Dreiphasenglei-chrichterbrücke (11) synchron von einer von einem Mikroprozessor (32) gesteuerten Logik betätigt werden.

9. Vorrichtung nach Anspruch 5, dadurch gekennzeichnet, dass der Umschalter (30) und die Schaltelemente ($V_1$ - $V_6$) der Dreiphasengleichrichterbrücke (11) vom gleichen elektronischen Steuer- und Synchronisierungskreis gesteuert werden.

10. Vorrichtung nach Anspruch 4, dadurch gekennzeichnet, dass der Verarbeitungskreis (20) ein logisches Rechenelement ist, welches durch Digitalberechnung die beiden Werte $k_1$, $k_2$ des Korrekturkoeffizienten bestimmen kann.

11. Vorrichtung nach Anspruch 10, dadurch gekennzeichnet, dass das logische Rechenelement ein Mikroprozessor (32) ist.

**0 159 201**

FIG.1

FIG.3

| | A | B | C | D | E | F |
|---|---|---|---|---|---|---|
| | 0 | T/6 | 2T/6 | 3T/6 | 4T/6 | 5T/6 | T |
| $V_1$ | 1 | 1 | ∅ | ∅ | ∅ | ∅ |
| $V_2$ | ∅ | 1 | 1 | ∅ | ∅ | ∅ |
| $V_3$ | ∅ | ∅ | 1 | 1 | ∅ | ∅ |
| $V_4$ | ∅ | ∅ | ∅ | 1 | 1 | ∅ |
| $V_5$ | ∅ | ∅ | ∅ | ∅ | 1 | 1 |
| $V_6$ | 1 | ∅ | ∅ | ∅ | ∅ | 1 |
| 21 | ∅ | ∅ | 1 | ∅ | ∅ | 1 |
| 22 | 1 | 1 | ∅ | 1 | 1 | ∅ |

FIG.2

FIG.2 waveforms (a) $i_1$, (b) $i_2$, (c) $i_3$, (d) $i_3-i_2$, (e) $i_3-i_2$, (f) i charge

1